# EUROPEAN PATENT SPECIFICATION

(11) **EP 0 902 471 B1**
(45) Date of publication and mention of the grant of the patent: **30.12.2009**
(21) Application number: 98306868.5
(22) Date of filing: 27.08.1998
(51) Int. Cl.: H01L 23/485, H01L 23/13, H01L 23/528

(54) **Semiconductor integrated circuit device and package structure for the same**
Integrierte Halbleiterschaltungsanordnung und Packungstruktur dafür
Dispositif semiconducteur à circuit intégré et structure d'empaquetage pour le dispositif

(30) Priority: 12.09.1997 JP 26778897
(43) Date of publication of application: 17.03.1999
(73) Proprietor: Oki Electric Industry Company, Limited, Tokyo 105 (JP)
(72) Inventor: Kohara, Youichi, 7-12, Toranomon 1-chome, Minato-ku Tokyo (JP); Oka, Takahiro, 7-12, Toranomon 1-chome, Minato-ku Tokyo (JP)
(74) Representative: Read, Matthew Charles

(56) References cited:
- EP-A- 0 431 490
- WO-A-95/28005
- JP-A- 09 064 232
- US-A- 5 155 065
- PATENT ABSTRACTS OF JAPAN vol. 012, no. 328 (E-654), 6 September 1988 (1988-09-06) & JP 63 093125 A (NEC CORP), 23 April 1988 (1988-04-23)
- PATENT ABSTRACTS OF JAPAN vol. 016, no. 570 (E-1297), 10 December 1992 (1992-12-10) & JP 04 221837 A (MITSUBISHI ELECTRIC CORP), 12 August 1992 (1992-08-12)

## Description

### Field of the Invention

The present invention relates to a semiconductor integrated circuit device and a package structure therefor.

### Background of the Invention

Electronic machinery and tool have made remarkable progress in recent years, especially in improvement of their performance, miniaturization and light weight, and further progress and improvement are still in demand. One of the most effective countermeasures complying with such demand is to reduce the number of semiconductor integrated circuit devices (referred to as 'IC device(s)' hereinafter) to be incorporated into electronic machinery and tool. Therefore, electronic machinery and tool manufacturers always wish to be supplied with IC devices which enable their designed large system including all the necessary peripheral circuits to be realized by only one IC device.

In compliance with such technical need, IC device manufacturers have been making every effort to realize a miniaturized and multi-layered wiring patterns for a semiconductor element (referred to as'chip' hereinafter) to be mounted on the IC device. Owing to this effort, the circuit portion (i.e. active area) constituted with transistors and other electronic parts has been made miniaturized to a great extent. As a matter of course, however, enlargement of IC device function is accompanied by increase in frequency of signal input/output (I/O) between the chip and its peripheral devices. This results in increase in the number of electrodes (bonding pads) connecting therebetween, so that the chip size can not help being enlarged after all.

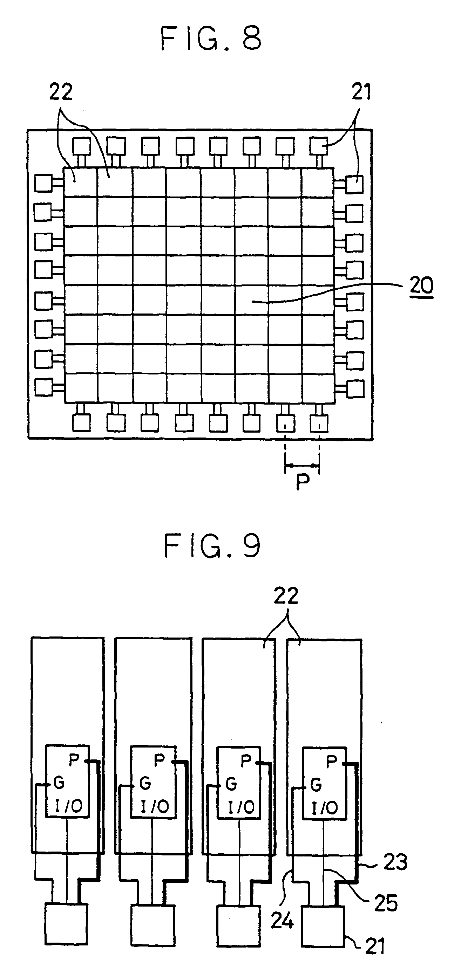

Fig. 8 illustrates an appearance of a typical chip pattern used for a gate array or the like. As shown in the figure, a circuit portion (active area) 20 is formed in the center part of the chip and a plurality of electrodes 21 are lined up at a predetermined pitch P along the periphery of the chip. The circuit portion (active area) 20 is formed as a set of a plurality of individual circuit portions 22 (referred to as 'unit cell' hereinafter). The electrode 21 is provided such that it makes one-to-one correspondence with the unit cell 22.

Fig. 9 is a conceptual illustration showing the basic design of each electrode. In general, the electrode 21 is disposed such that it can be individually connected with a power source terminal (P), a ground terminal (G), and a signal input/output (I/O) terminal of a corresponding unit cell 22, through an electrode wiring 23, a ground wiring 24, and a signal I/O wiring 25, respectively. In other words, this means that each of electrodes 21 can optionally use any one of the power source terminal (P), the ground terminal (G), and the signal I/O terminal, depending on a given request. Therefore, this basic wiring design is able to remarkably increase the degree of freedom in the IC design work. Accordingly, in case of designing the IC device actually, the basic design of the entire chip can be achieved by first making a basic design unit including a unit cell and electrodes therefor, then duplicating the basic design unit by the necessary number of it, and finally, disposing those which are duplicated.

Actual chips are manufactured through a predetermined wafer process using wafer masks which are prepared based on the above-mentioned basic design. To be more concrete, it is first decided, depending on the request, whether the electrode is to be used for input/output of signal, for supplying power, or for grounding. Then, wafer masks are manufactured such that wiring is carried out so as to satisfy the above decision.

In general, the wafer mask is formed so as to have a multi-layer structure, that is, it consists of a common mask for use in formation of the circuit portion, and a mask for use in formation of a wiring layer. When a special wiring demand arises, this can be complied with by just altering some of wiring layer masks. Accordingly, a variety of masks are prepared, for instance, one having a wiring pattern in which a certain electrode is connected only with the I/O terminal but with nothing else, and the other having a wiring pattern in which a certain electrode is connected only with the power terminal but with nothing else. A chip can be completed through the wafer process as mentioned above. Accordingly, if the chip is manufactured through the above-mentioned manufacturing process, days spent for manufacturing the chip can be effectively shortened, because its basic design is already available as mentioned above and what to be done is to only prepare the masks which meet the client's demand.

By the way, it should be considered that the pitch P of disposing electrodes considerably depends on the technical level on how to connect the electrode with the unit cell. If electrode connection is carried out by a wire bonding method, for instance the most widely used thermosonic wire bonding method, the possible minimum pitch is in a range of 100 to 80 µm, so that the circuit portion can not help being designed by taking account of this available pitch range. Recently, however, it has become possible to design a circuit portion (active area) with a microminiature size, owing to remarkable progress in the microminiaturization and multilevel interconnection technology adaptable to the wafer process. On the other hand, however, it is the true present state that the technology of electrode connection has not caught up with this microminiaturization technology as yet.

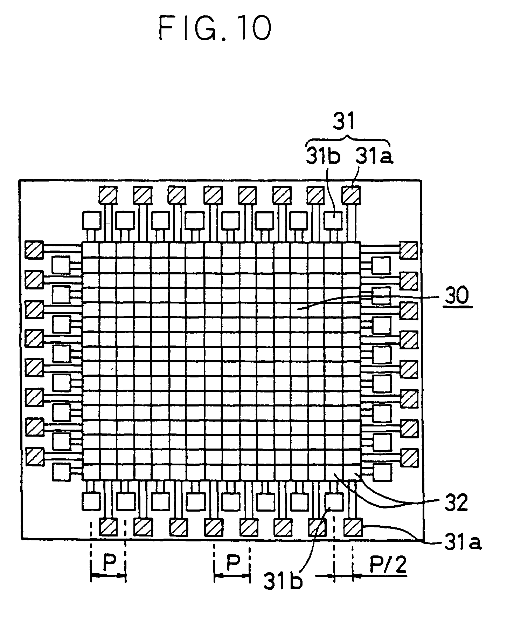

Therefore, it sometimes happens that the chip fails to accommodate the number of electrodes which may correspond to the scale of the inner circuit. The known arrangement of electrodes 31 (31a, 31b) in a zigzag fashion as shown in Fig. 10 is one of countermeasures as devised in order to increase the number of electrodes to be disposed on a chip. According to this electrode arrangement, if respective alignment pitches of the electrode 31a aligned along the periphery a little to the center part of the chip and the electrode 31b aligned inside that periphery are commonly set as a value of P, the pitch between the outer electrode 31a and the inner electrode 31b can be made P/2, so that the chip size can be made smaller as a result. Here, a reference numeral 30 designates the circuit portion (active area) and 32 does the unit cell.

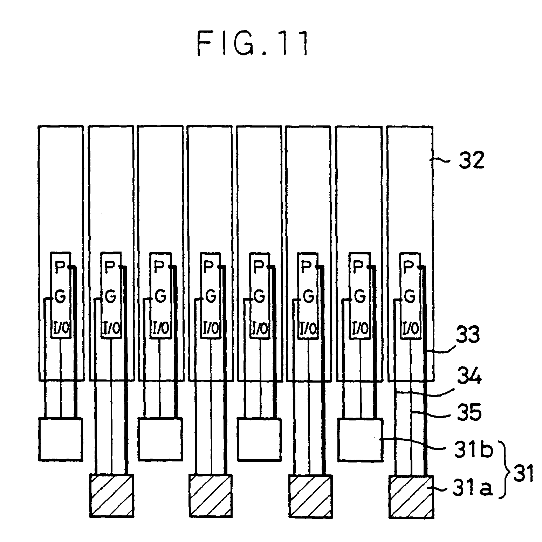

Fig. 11 is a conceptual illustration for explaining the basic design of the electrode arrangement in a zigzag fashion. Similar to the wiring arrangement as shown in Fig. 9, the electrode 31 is disposed such that it can be individually connected with a power source terminal (P), a ground terminal (G), and a signal input/output (I/O) terminal of the unit cell 32 corresponding to the electrode 31, through an electrode wiring 33, a ground wiring 34, and a signal I/O wiring 35, respectively. Therefore, it again becomes possible in this zigzag electrode arrangement that each electrode can be optionally assigned to power supply use, grounding, or the signal I/O. Thus, this zigzag electrode arrangement can contribute to reduction of the chip size, because this electrode arrangement allows the chip to accommodate a large number of electrodes which are inevitable for operation of the circuit portion, even if they are not allowed to be disposed in a single line along the periphery of the chip.

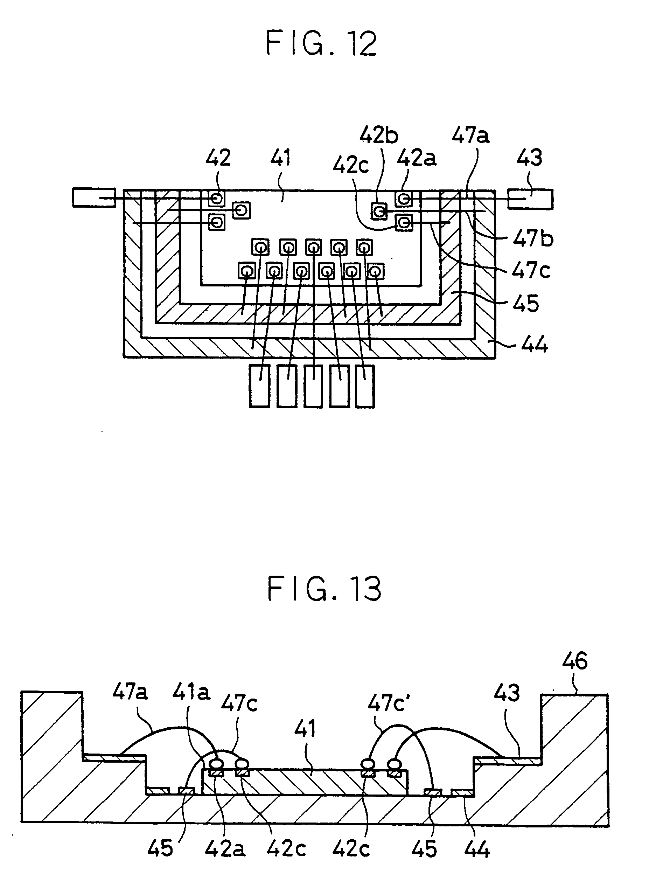

In the next, a method for putting such a chip as manufactured above in a package, especially by means of the wire bonding process, will be described with reference to Figs. 12 and 13. Fig. 12 is a schematic plan view of a wiring portion while Fig. 13 is a schematic cross sectional view of the wiring portion as shown in Fig. 12.

By the way, in case of a chip which is required to execute the signal I/O operation at an operating frequency of about 80 MHz or more, it is a very much effective countermeasure against noise to dispose the power supply and the ground separately from each other within the package. For this, it is widely known to apply such a multi-layer structure as shown in Fig. 13 to the package body. Epoxy board and ceramic board are used as a material for forming the multi-layer package body 46. Electrode 42 formed on the chip 41 is arranged in a zigzag manner like the above-mentioned. As shown in the figure, an input/output inner lead 43 is properly placed on the multi-layer package body 46. Inside this inner lead 43, there are disposed a common power supply ring 44 and a common ground ring 45 so as to surround a chip 41.

As has been already described, since each of electrodes may be optionally used as either a signal I/O electrode, a power supply electrode, or a ground electrode, assignment of them is determined according to a given individual request. For instance, therefore, complying with the request, the signal I/O electrode 42a is connected with the inner lead 43 through a wiring 47a, the power supply electrode 42b is connected with the common power supply ring 44 through a wiring 47b, and the ground electrode 42c is connected with the common ground ring 45 through a wiring 47c. In this way, the wire bonding process is completed when necessary wirings are over.

Heretofore, even in case of a chip which is required not to operate so fast, but to operate at an operating frequency of about 80 MHz or less, about 20 to 30% of electrodes formed on a single chip have been used as power supply electrodes and/or ground electrodes. Therefore, only 80 to 70% of electrodes have been left for use in signal input/output operation. For instance, even if 208 electrodes can be formed on a chip, only 140 to 160 electrodes can be used for signal input/output operation. This means that only about 80 to 70% of the circuit portion (active area) can be used actually. Consequently, in order to satisfy the actual demand, it is required to prepare a chip having the number of electrodes larger than that which is actually needed. This naturally causes enlargement of the chip size and is not only against miniaturization of the chip size but also against reduction of manufacturing cost.

Furthermore, in case of a chip which is required to operate at a higher operating frequency such as 80 MHz or more, the number of electrodes for use in power supply and/or ground would have to be further increased taking account of a countermeasure against noise. Otherwise, the number of electrodes for signal I/O use can not help being relatively decreased. Accordingly, in order to secure the necessary number of signal I/O electrodes, the chip has to be further made larger in its size. As mentioned above, this is against miniaturization of the chip and causes the rise in the manufacturing cost.

In order to avoid noise interference, it is well known to shield the signal I/O electrode. In this case, shielding is achieved by putting the signal I/O electrode between the power supply electrode and the ground electrode. According to this method, however, in order to satisfy the demand, the chip has to be selected so as to include the number of electrodes larger than the necessary number of signal I/O electrodes. As a matter of course, this causes another increase in chip size against miniaturization thereof, and causes the rise in the manufacturing cost after all.

As described in the above, the prior art electrode arrangement in the IC device can no longer comply with the demand relating to the number and pitch of electrodes capable of completely satisfying all the functions of the microminiaturized circuit portion, which has been achieved through the recent remarkable progress in the wafer process technology, especially in microminiaturization of the circuit portion with the help of the multi-layer structure. Even the zigzag electrode arrangement still fails to use all the functions obtainable from the circuit portion, rather causing the rise in the manufacturing cost as described above.

Furthermore, in case of a chip which is required to execute signal I/O operation at a higher operating frequency such as about 80 MHz or more, and of which electrodes are disposed in a zigzag fashion, it has been sometimes experienced that the ordinary wire bonding process meets with some difficulties when incorporating the chip into a package in a usual manner, depending on positioning of the signal I/O electrode, the power supply electrode, and the ground electrode. For instance, as shown on the left side of Fig. 13, the wiring 47c serves for connecting the electrode 42c with the common power supply ring 45 (or the common ground ring 44). However, since the electrode 42c is located inward far from the chip edge 41a while the power supply ring 45 takes a lower position near the chip, the height of the wiring 47c is apt to become lower if it is formed according to the ordinary wire bonding process. Therefore, there might be caused such a risky state that the wiring 47c gets in touch with the chip edge 41a. In order to avoid this risky state, it would be required to take some action such as keeping the wiring 47c away from the edge 41a, for instance rising the height of the wiring 47 like the wiring 47c' as shown on the right side of Fig. 13. This would require special control or modification of the wire bonding process, which would result in another rise in the manufacturing cost. JP9064232 discloses a semiconductor device in accordance with the precharacterising portion of the appended claims, i.e an IC device provided with a chip in which a signal I/0 wiring is located between power supply and ground wirings, thereby being well protected from noise such as crosstalk, and which can run well at a very high operating frequency.

The IC device is fabricated in a package having a multi-layer structure by means of a stable and reliable ordinary bonding process without need of any special wiring control.

### Summary of the Invention

The present invention has been made in view of the above-mentioned problems in association with the prior art IC device. Therefore, an object of the invention is to provide a novel and improved IC device wherein the circuit portion (action area) of the chip can be made full use of without increasing the number of electrodes, thereby enabling the chip size to be made relatively smaller and realizing cost reduction in the IC device manufacture.

Therefore, the present invention provides a semiconductor IC device comprising:
an active area consisting of a plurality of unit cells;
a plurality of electrodes disposed in a zigzag fashion in first and second rows, along the periphery of said active area;
a plurality of signal I/0 electrodes disposed on the first row of said zigzag electrode arrangement; and
a plurality of power supply electrodes and ground electrodes alternately disposed on the second row of said zigzag electrode arrangement characterised in that
said plurality of unit cells include first unit cells of which each has a signal I/0 terminal and a power supply terminal, and second unit cells of which each has a signal I/0 terminal and a ground terminal; and
said active area is achieved by alternately disposing said first unit cells and said second unit cells.

With the constitution like this, as the power supply electrode and the ground electrode are provided separately from the signal I/O electrode, a sufficient number of power supply and ground electrodes can be secured even in the case that all of available signal I/O electrodes are fully used for maximum operation of the circuit portion. Consequently, an optimum chip size can be selected in correspondence with the necessary number of electrodes.

The invention may still further provide an IC device wherein a signal I/O wiring for connecting the signal I/O terminal with the signal I/O electrode is made to locate between a power supply wiring for connecting the power supply terminal with the power supply electrode and a ground wiring for connecting the ground terminal with the ground electrode. This well protects the chip from noise such as crosstalk, and gives the optimum structure to the chip which is required to run at a very high operating frequency.

Furthermore, the above first row on which signal I/O electrodes are disposed, is located to be a little near to the active area than the second row on which power supply electrodes and ground electrodes are alternately disposed.

There is provided a package for use in fabricating the IC device as constituted above. This package has a multi-layer structure with at least two layers, on the first layer of which a common power supply ring and a common ground ring are disposed, and on the second layer of which a signal I/O lead is disposed.

With this constitution of the package, the signal I/O lead, the power supply electrode, and ground electrode may be stably and reliably connected with the signal I/O electrode, the common power supply ring, and the common ground ring, respectively, through the ordinary wire bonding process without performing a special wiring control therein, thereby enabling stable and reliable packaged IC devices to be produced.

### Brief Description of the Drawings

The above and other features of the invention and the concomitant advantages will be better understood and appreciated by persons skilled in the field to which the invention pertains in view of the following description given in conjunction with the accompanying drawings which illustrate preferred embodiments.
In the drawings:
Fig. 1 is a schematic plan view showing the chip structure of an IC device according to the embodiment of the invention;
Fig. 2 is an enlarged view of wiring portions between electrodes and unit cells of the IC device as shown in Fig. 1;
Fig. 3 is a partial plan view showing an example of a package structure as used for the IC device shown in Fig. 1;
Fig. 4 is a schematic cross sectional view of the package structure shown in Fig. 3;
Fig. 5 is a schematic plan view showing the structure of an IC device according to a first example not falling under the claimed invention;
Fig. 6 is an enlarged view of wiring portions between electrodes and unit cells of the IC device as shown in Fig. 5;
Fig. 7 is an enlarged view of wiring portions between electrodes and unit cells of the IC device according to a second example not falling under the claimed invention;
Fig. 8 is a schematic plan view of the chip structure as used in an example of a prior art IC device;
Fig. 9 is an enlarged view of wiring portions between electrodes and unit cells of the IC device as shown in Fig. 8;
Fig. 10 is a schematic plan view of the chip structure as used in another example of a prior art IC device;
Fig. 11 is an enlarged view of wiring portions between electrodes and unit cells of the IC device as shown in Fig. 10;
Fig. 12 is a partial plan view showing an example of a package structure as used for the IC device shown in Figs. 10 and 11;
Fig. 13 is a schematic cross sectional view of the package structure shown in Fig. 12.

### Preferred Embodiment of the Invention

The preferred embodiment of the IC device according to the invention will now be described in the following with reference to the accompanying drawings.

### (Preferred Embodiment)

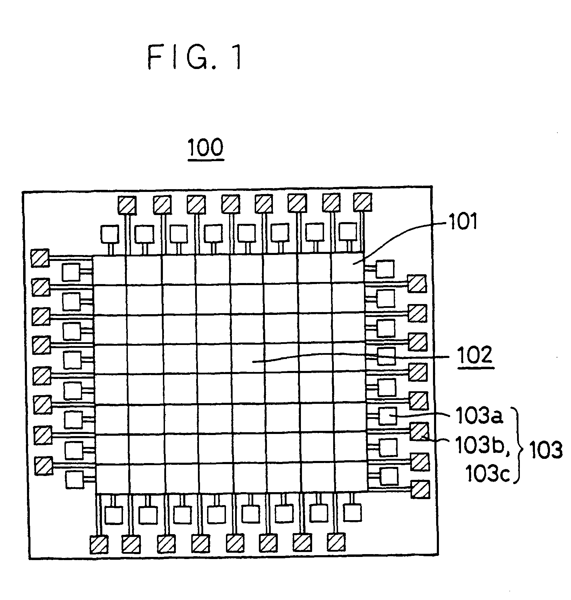

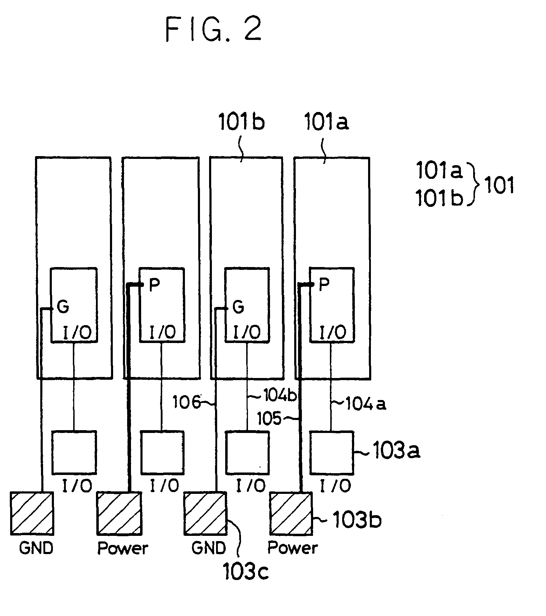

Fig. 1 is a schematic plan view showing the chip structure of an IC device according to the embodiment of the invention, and Fig. 2 is a conceptual diagram for explaining a basic design of respective electrodes according to this embodiment. As shown in these figures, a chip 100 includes a circuit portion (active area) 102 in which a plurality of individual circuit portion (unit cell) 101 are arranged in the form of a matrix, and a plurality of electrodes 103 which are arranged in a zigzag fashion along the periphery of the active area 102 so as to surround it. In the device according to this embodiment, different from the prior art IC device, an electrode group 103 consists of signal I/O electrodes 103a, power supply electrodes 103b, and ground electrodes 103c, the first electrodes 103a being disposed along the periphery a little to the center of the chip (referred to as 'inner periphery' hereinafter), and other two 103b, 103c being alternately disposed along the periphery outside the above inner periphery of the chip (referred to as 'outer periphery' hereinafter), so that each electrode can be connected with each unit cell 101 on the basis of one-to-one correspondence.

Next, the constitution of the IC device according to this embodiment will be more concretely described with reference to Fig. 2. In the following description, for the purpose of simplifying the way of writing, explanation on a plurality of like electrodes, like unit cells, and others if any, will be made by using a representative item selected therefrom. In the unit cell 101a, its signal input/output (I/O) terminal is connected, through a signal I/O wiring 104a, with the signal I/O electrode 103a which is disposed along the inner periphery of the chip, and the power supply terminal (P) is connected, through a power supply wiring 105, with the power supply electrode 103b which is disposed along the outer periphery of the chip.

In another unit cell 101b, its signal I/O terminal is connected in the same manner as the unit cell 101a, through a signal I/O wiring 104b, with the signal I/0 electrode 103a which is disposed along the inner periphery of the chip, and the ground terminal (G) is connected, through a ground wiring 106, with the ground electrode 103c which is disposed along the outer periphery of the chip.

As mentioned above, according to the present embodiment, the unit cell 101a which is connected with the signal I/O electrode 103a and the power supply electrode 103b, is alternately disposed with the unit cell 101b which is connected with the signal I/O electrode 103a and the ground electrode 103c. Accordingly, in the basic chip design according to this embodiment, two unit cells 101a and 101b are constituted as one set. Therefore, the basic design of one chip is completed by means of making copies of the above basic set by the necessary number and disposing them in a desired pattern.

In the example as shown above, the signal I/O electrode 103a is located along the inner periphery of the chip, and the power supply electrode 103b and the ground electrode 103c are located along the outer periphery of the chip. However, the invention should not be limited to this way of electrode arrangement. Needless to say, the reverse electrode arrangement, namely locating the power supply electrode 103b and the ground electrode 103c along the inner periphery of the chip, and locating the signal I/O electrode 103a along the outer periphery of the chip, may give the same effect as the former electrode arrangement.

When a basic design of the chip 100 is finished in the way as described above, the chip 100 is then manufactured through a predetermined wafer process using wafer masks prepared based on the above basic design. More concretely, every unit cell 101 (101a, 101b) is connected with the signal I/O electrode 103a through respective signal I/O wirings 104a and 104b. In addition, the power supply terminal (P) and the ground terminal (G) of the unit cell 101 (101a, 101b) are alternately connected with the power supply and ground electrodes 103b and 103c through the power supply wiring 105 and the ground wiring 106, respectively. Accordingly, for instance, in case of the IC device according to the embodiment of invention, if its circuit portion 102 contains 208 unit cells 101, 104 each of power supply and ground electrodes 103b, 103c come to be available separately from 208 signal I/O electrodes 103a corresponding to those unit cells.

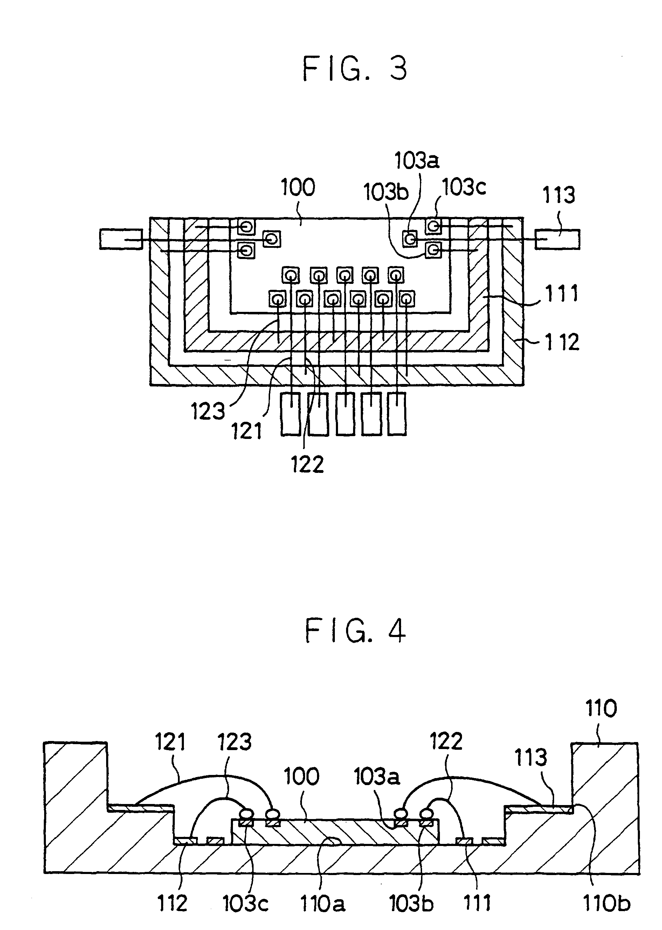

In the next, a method for putting the IC device having the above constitution in a package, especially by means of the wire bonding process, will be described with reference to Figs. 3 and 4. Here, Fig. 3 is a schematic plan view of a wiring portion while Fig. 4 is a schematic cross sectional view of the wiring portion as shown in Fig. 3.

As has been described already, in case of the chip 100 which is required to execute the signal I/O operation at an operating frequency of about 80 MHz or more, it is very much effective countermeasure against noise to dispose the power supply and the ground separately from each other within the package. For this, it is widely known to apply such a multi-layer structure as shown in Figs. 3 and 4 to the package body. Epoxy board and ceramic board are used as a material for forming the multi-layer package body 110. As shown in Fig. 4, the multi-layer package body 110 consists of the first layer 110a and the second layer 110b. The former (110a) includes a chip 100 disposed about in the center thereof, a common power supply ring 111 disposed so as to surround the chip 100, and a common ground ring 112 disposed so as to surround the ring 111, while the latter (110b) includes a signal I/O inner lead 113 disposed at a level higher than the first layer 110a.

In the example shown in Fig. 4, the signal I/O electrode 103a disposed along the inner periphery of the chip 100 is connected, through a wiring 121, with the inner lead 113 formed on the outer periphery of the package body 110. The power supply electrode 103b disposed along the outer periphery of the chip 100 is connected with the common power supply ring 111 positioned in the most inside of the package bogy 110 through a wiring 122. The ground electrode 103c also disposed along the outer periphery of the chip is connected with the common ground ring 112 positioned in the outside of the common power supply ring 111 through a wiring 123. The wire bonding process is completed when the above wiring operation is over.

According to the above-mentioned wiring structure, as the signal I/O electrode 103a located along the inner periphery of the chip 100 is connected with the inner lead 113 of the package body 110 through the wiring 121, it becomes possible to keep the height of the wiring 121 higher. Therefore, different from the case of the prior art IC device (Fig. 13), there is no fear that the height of the wiring 47c is made so lower that it gets in touch with the edge of the chip 41. Consequently, control of the wire bonding process is made easier.

As has been discussed in the above, according to the present embodiment of the invention, the following effect and advantage will be expected.

First of all, as the power supply electrode 103b and the ground electrode 103c are provided separately from the signal I/O electrode 103a, the sufficient number of power supply and ground electrodes can be secured even in the case that all of available signal I/O electrodes 103a are fully used for maximum operation of the circuit portion 102. This makes it possible to select an optimum chip size corresponding to the necessary number of the electrodes. Furthermore, it becomes possible to reduce the chip size comparing to the case of prior art IC device, and to lower the manufacturing cost. For instance, in case of the IC device according to the embodiment of invention, if its circuit portion 102 contains 208 unit cells 101, 104 each of power supply and ground electrodes 103b, 103c can be secured separately from 208 signal I/O electrodes 103a corresponding to those unit cells.

Furthermore, power supply and ground electrodes 103b and 103c are alternately disposed with respect to the signal I/O electrode 103a, thereby the signal I/O electrodes 103a being well protected from noise such as crosstalk. Thus, the IC device according to the embodiment of the invention can comply with the demand for high speed operation at an operating frequency of 80 MHz or more. What is more advantageous, the optimum chip size to be used in the IC device operable at such a high operating frequency can be selected so as to correspond to the number of electrodes, thus enabling the manufacturing cost to be lowered.

Furthermore, according to the embodiment of the invention, the chip can be selected so as to accommodate the designed optimum number of electrodes, and these electrodes can be disposed in a zigzag fashion, thus enabling the chip size to be comparatively made smaller to the number of electrodes.

In addition, as shown in Figs. 3 and 4, since the power supply and ground electrodes 103b and 103c are disposed along the outer periphery of the chip 100, the height of wirings 122 and 123 can be kept higher to some extent. Consequently, there is no fear that wirings 122 and 123 get in touch with the edge of the chip 100, so that stable and high quality wirings can be achieved even through the ordinary wire bonding process without carrying out any special control therein.

First example not forming part of the claimed invention.

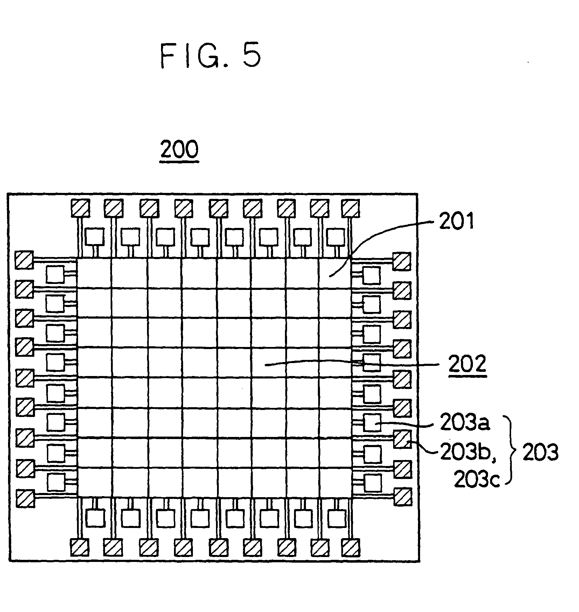

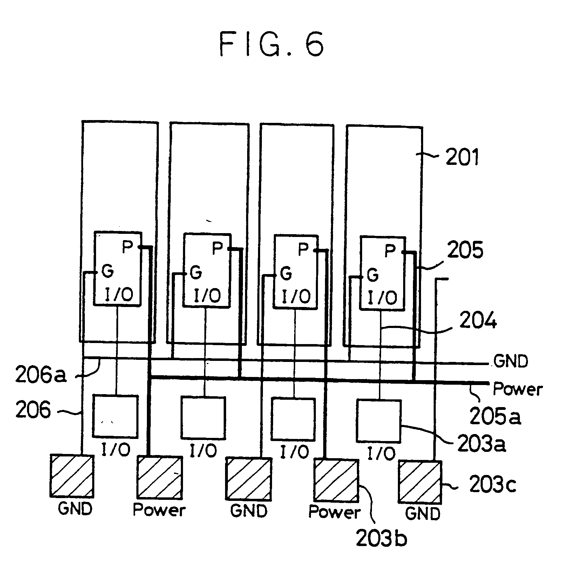

In the next, the IC device according to the first example not forming part at the claimed invention will be described with reference to Figs. 5 and 6.

Constitution of the IC device 200 according to this first example not forming part at the claimed invention is approximately similar to that of the IC device according to the embodiment of the the invention, and a plurality of electrodes 203 are disposed in a zigzag fashion around the periphery of a circuit portion (active area) 202 in which a plurality of individual circuit portions (unit cells) 201 are arranged in the form of a matrix. Each electrode 203 is formed as an electrode group consisting of a signal I/O electrode 203a which is disposed along the inner periphery of the chip, and the power supply and ground electrodes 203b and 203c which are alternately disposed along the outer periphery of the chip and thus each electrode 203 is connected with each corresponding unit cells 201.

Next, the constitution of the IC device according to this embodiment will be more concretely described with reference to Fig. 6. The signal input/output (I/O) terminal of each unit cell 201 is connected, through a signal I/O wiring 204, with the signal I/O electrode 203a which is disposed along the inner periphery of the chip. The power supply terminal (P) of each unit cell 201 is connected, through a power supply wiring 205, with the power supply electrode 203b which is disposed along the outer periphery of the chip. In this case, the power supply wiring 205 for each unit cell 201 is further connected with a common wiring 205a. In the same manner, the ground terminal (G) of each unit cell 201 is connected, through a ground wiring 206, with the ground electrode 203c which is disposed along the outer periphery of the chip. The ground wiring 206 is also connected with another common wiring 206a in the same manner as the power supply wiring 205.

According to the wiring structure as mentioned above, power supply and ground electrodes 203b and 203c are respectively connected with two common wirings 205a and 206a, so that the degree of freedom in the wiring design is enlarged, and different from the first embodiment, each unit cell 201 is allowed to have an identical structure which is equally provided with the signal I/O terminal (I/O), the ground terminal (G), and the power supply terminal (P).

In the example as shown above, the signal I/O electrode 203a is located along the inner periphery of the chip, and the power supply electrode 203b and the ground electrode 203c are located along the outer periphery of the chip. However, the first example should not be limited to this way of electrode arrangement. Needless to say, the reverse electrode arrangement, namely locating the signal I/O electrode 203a along the outer periphery of the chip, and locating the power supply and ground electrodes 203b, 203c along the inner periphery of the chip, may give the same effect as the former electrode arrangement.

When a basic design of the chip 200 is finished as described above, the chip 200 is then manufactured through a predetermined wafer process using wafer masks prepared based on the above basic design. More concretely, the signal I/O electrode 203a is connected with the corresponding unit cell 201 through the signal I/O wiring 204. The power supply electrode 203b is connected with the power supply terminal (P) of the corresponding unit cell 201 through the power supply wiring 205 and the common wiring 205a. The ground electrode 203c is connected with the ground terminal (G) of the corresponding unit cell 201 through the ground wiring 206 and the common wiring 206a. Consequently, if 208 unit cells 201 are contained in the circuit portion 202 of the IC device according to the the first example, 104 each of power supply and ground electrodes 203b and 203c come to become available separately from 208 signal I/0 electrodes 203a corresponding to those unit cells.

As described in the above, according to the first example not forming part of the claimed invention, in addition to advantageous effect given by the IC device according to the first example not forming part of the claimed invention, there is given another advantageous features that the structure of the unit cell 201 is unified, that the chip design is simplified, and also that the degree of freedom is expanded in the chip design.

### Second example not forming part of the claimed invention

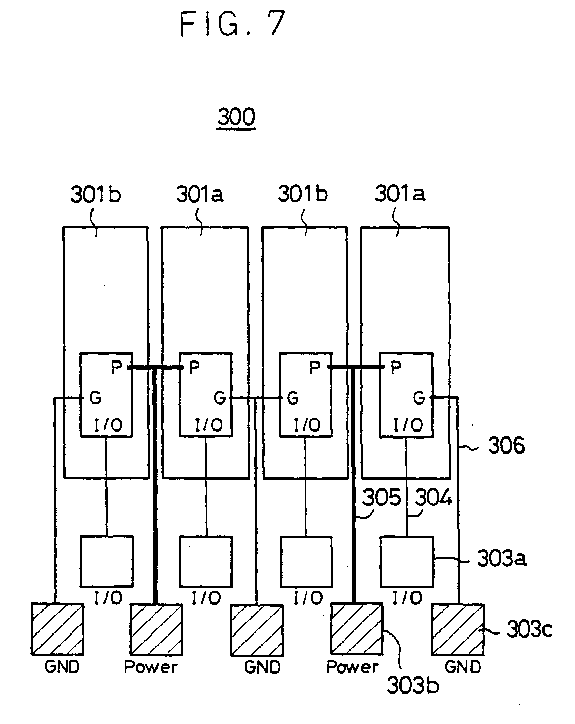

In the next, constitution of the IC device according to the second example not forming part of the claimed invention will be described with reference to Fig. 7.

This IC device 300 has an almost identical constitution to those which have been described in connection with the embodiment of the invention and the first example not forming part of the claimed invention. In this example, electrodes 303a, 303b, and 303c are arranged in a zigzag fashion along the periphery of the unit cell 301a and 301b which are disposed in the form a matrix. In the same manner as in the embodiment of the invention and the first example not forming part of the claimed invention, a signal I/0 electrode 303a is disposed along the inner periphery of the chip 300 while the power supply electrode 303b and the ground electrode 303c are alternately disposed along the outer periphery of the chip 300.

And also, in this second example not forming part of the claimed invention, each of terminals provided in respective unit cells 301a and 301b is connected with necessary corresponding electrodes in the same manner as in the embodiment of the invention and the first example not forming part of the claimed invention, that is, the signal I/0 terminal (I/0) being connected with the signal I/0 electrode 303a through a signal I/0 wiring 304, the power supply terminal (P) with the power supply electrode 303b through a power supply wiring 305, and the ground terminal (G) with the ground electrode 303c through a ground wiring 306. Although a signal I/O terminal (I/O), power supply terminal (P) and ground terminal (G) for each corresponding unit cells 301a are provided as same as the first example not forming part of the claimed invention, in this example, adjacent unit cells 301a and 301b are designed to have such a mirror structure that two power supply terminals are disposed adjacent to each other and also two ground terminals are done the same.

With arrangement of unit cells and wirings as mentioned above, another advantageous effect can be produced in addition to that which is obtained in the above first example. Namely, in case of disposing plurality of pairs of unit cells 301a and 301b in a desirous form, their like terminals i.e. two each of supply terminals (P) and ground terminals (G) come to be respectively placed side by side. Consequently, connection of the power supply terminal (P) and the power supply electrode 303b, and the same of the ground terminal (G) and the ground electrode 303c can be achieved by means of a short common wiring. This advantageously acts, especially for the chip required to do high speed operation.

As mentioned above, unit cells 301a and 301b are formed to have the mirror structure. Therefore, there is no need for them to be designed separately. That is, if the unit cell 301a is designed as a standard unit cell, the counterpart unit cell 301b can be obtained by just inverting the unit cell 301a in the mirror symmetry. Accordingly, two sorts of unit cells can be obtained by designing only one standard unit cell without carrying out two sorts of designs.

As has been discussed so far, according to the invention, since power supply and ground electrodes can exist separately from the signal I/O electrode, the sufficient number of power supply and ground electrodes can be secured even in the case that all of available signal I/O electrodes are fully used for maximum operation of the circuit portion. This makes it possible to select an optimum chip size corresponding to the necessary number of the electrodes. Thus, it becomes possible to reduce the chip size comparing to the case of prior art IC device, and to lower the manufacturing cost.

Furthermore, power supply and ground electrodes are alternately disposed with respect to the signal I/O electrode, thereby the signal I/O electrodes 103a being well protected from noise such as a crosstalk. Accordingly, the invention may be preferably applied to the chip, especially one which is required to operate at a high operating frequency.

In addition, in case of assembling the chip in a multi-layer package, it may be avoided that wirings get in touch with any part of the chip, so that stable and reliable quality wirings can be achieved even through the ordinary wire bonding process without carrying out a special control therein.

## Claims

1. A semiconductor IC device (100) comprising:
an active area (102) consisting of a plurality of unit cells (101);
a plurality of electrodes (103) disposed in a zigzag fashion in first and second rows, along the periphery of said active area (102);
a plurality of signal I/O electrodes (103a) disposed on the first row of said zigzag electrode arrangement; and
a plurality of power supply electrodes (103b) and ground electrodes (103c) alternately disposed on the second row of said zigzag electrode arrangement
**characterised in that**
said plurality of unit cells (101) include first unit cells(101a) of which each has a signal I/0 terminal and a power supply terminal, and second unit cells (101b) of which each has a signal I/0. terminal and a ground terminal; and
said active area (102) is achieved by alternately disposing said first unit cells (101a) and said second unit cells (101b).

2. A semiconductor IC device as claimed in claim 1, wherein a signal I/0 wiring (104a, 104b) for connecting said signal I/0 terminal with said signal I/0 electrode (103a) is located between a power supply wiring (105) for connecting said power supply terminal with said power supply electrode (103b) and a ground wiring (106) for connecting said ground terminal with said ground electrode (103c).

3. A semiconductor IC device as claimed in claim 1 or 2, wherein said first row on which signal I/0 electrodes (103a) are disposed is located closer to said active area (102) than said second row on which power supply electrodes (103b) and ground electrodes (103c) are alternately disposed.

4. A package comprising a semiconductor IC device in accordance with any one of the preceding claims, and a package body (110);
wherein said package body (110) has a multi-layer structure with at least two layers, wherein a common power supply ring (111) and a common ground ring (112) are disposed on a first layer so as to surround the semiconductor IC device (100), and a signal I/0 lead (113) is disposed on a second layer.

## Patentansprüche

1. Halbleiter-IC-Gerät (100), umfassend:
eine aktive Fläche (102), bestehend aus einer Mehrzahl von Elementzellen (101);
eine Mehrzahl von Elektroden (103), die in einer Zickzack-Anordnung in einer ersten und einer zweiten Reihe entlang der Peripherie des aktiven Feldes (102) angeordnet sind;
eine Mehrzahl von Signal-I/0-Elektroden (103a), die in der ersten Reihe der Zickzack-Elektrodenanordnung angeordnet sind;
eine Mehrzahl von Energieversorgungselektroden (1 03b) und Masseelektroden (103c), die abwechselnd in der zweiten Reihe der Zickzack-Elektrodenanordnung angeordnet sind,
**dadurch gekennzeichnet, dass**
die Mehrzahl von Elementzellen (101) erste Elementzellen (101 a), von denen jede einen Signal-I/O-Anschluss und einen Energieversorgungsanschluss aufweist, und zweite Elementzellen (101b) enthält, von denen jede einen Signal-I/O-Anschluss und einen Masseanschluss aufweist; und
das aktive Feld (102) durch abwechselndes Anordnen der ersten Elementzellen (101 a) und der zweiten Elementzellen (101b) erhalten wird.

2. Halbleiter-IC-Gerät nach Anspruch 1, wobei sich eine Signal-I/O-Verdrahtung (104a, 104b) zum Verbinden des Signal-I/O-Anschlusses mit der Signal-I/O-Elektrode (103a) zwischen einer Energieversorgungsverdrahtung (105) zum Verbinden des Energieversorgungsanschlusses mit der Energieversorgungselektrode (103b) und einer Masseverdrahtung (106) zum Verbinden des Masseanschlusses mit der Masseelektrode (1 03c) befindet.

3. Halbleiter-IC-Gerät nach Anspruch 1 oder 2, wobei sich die erste Reihe, auf welcher die Signal-I/O-Elektroden (103a) angeordnet sind, näher an dem aktiven Feld (102) als die zweite Reihe befindet, auf welcher die Energieversorgungselektroden (103b) und die Masseelektroden (103c) abwechselnd angeordnet sind.

4. Baugruppe, umfassend ein Halbleiter-IC-Gerät in Übereinstimmung mit einem der vorhergehenden Ansprüche und einem Baugruppenkörper (110);
wobei der Baugruppenkörper (110) eine Mehrschicht-Struktur mit wenigstens zwei Schichten aufweist, wobei ein gemeinsamer Energieversorgungsring (111) und ein gemeinsamer Massering (112) auf einer ersten Schicht derart angeordnet sind, das Halbleiter-IC-Gerät (100) zu umgeben, und wobei ein Signal-I/O-Leiter (113) auf einer zweiten Schicht angeordnet ist.

## Revendications

1. Dispositif de circuit intégré (100) à semi-conducteurs comprenant :
une zone active (102) constituée d'une pluralité de cellules unitaires (101) ;
une pluralité d'électrodes (103) disposées en zigzag en des première et seconde rangées, le long de la périphérie de ladite zone active (102) ;
une pluralité d'électrodes (103a) d'entrée/sortie (I/O pour "In/Out") de signal disposées sur la première rangée dudit agencement d'électrodes en zigzag ; et
une pluralité d'électrodes (103b) d'alimentation et d'électrodes (103c) de masse disposées alternativement sur la seconde rangée dudit agencement d'électrodes en zigzag,
**caractérisé :**
**en ce que** ladite pluralité de cellules unitaires (101) inclut des premières cellules unitaires (101a) dont chacune possède une borne d'I/O de signal et une borne d'alimentation, et des secondes cellules unitaires (101b) dont chacune possède une borne d'I/O de signal et une borne de masse ; et
**en ce que** ladite zone active (102) est achevée en disposant alternativement lesdites premières cellules unitaires (101a) et lesdites secondes cellules unitaires (101b).

2. Dispositif de circuit intégré à semi-conducteurs selon la revendication 1, dans lequel un câblage (104a, 104b) d'I/O de signal destiné à connecter ladite borne d'I/O de signal avec ladite électrode (103a) d'I/O de signal est situé entre un câblage (105) d'alimentation destiné à connecter ladite borne d'alimentation avec ladite électrode (103b) d'alimentation et un câblage (106) de masse destiné à connecter ladite borne de masse avec ladite électrode (103c) de masse.

3. Dispositif de circuit intégré à semi-conducteurs selon la revendication 1 ou 2, dans lequel ladite première rangée sur laquelle sont disposées des électrodes (103a) d'I/O de signal est située plus près de ladite zone active (102) que ladite seconde rangée sur laquelle sont disposées alternativement des électrodes (103b) d'alimentation et des électrodes (103c) de masse.

4. Boîtier comprenant un dispositif de circuit intégré à semi-conducteurs selon l'une quelconque des revendications précédentes, et un corps (110) de boîtier ;
dans lequel ledit corps (110) de boîtier a une structure multicouche avec au moins deux couches, dans lequel un anneau (111) d'alimentation commune et un anneau (112) de masse commune sont disposés sur une première couche de façon à entourer le dispositif de circuit intégré (100) à semi-conducteurs, et dans lequel un conducteur (113) d'I/O de signal est disposé sur une seconde couche.
